# EUROPEAN PATENT APPLICATION

(11) **EP 4 793 932 A1**
(43) Date of publication of application: **19.08.2026**
(21) Application number: 25823311.3
(22) Date of filing: 29.08.2025
(51) Int. Cl.: G09G 3/3225

(54) **DISPLAY PANEL AND DISPLAY APPARATUS**

(30) Priority: 27.12.2024 CN 202411958860
(71) Applicant: Shanghai Tianma Microelectronics Co., Ltd., Shanghai 201201 (CN)
(72) Inventor: LIN, Lizi, Shanghai 201201 (CN); GAO, Yana, Shanghai 201201 (CN); ZHOU, Xingyao, Shanghai 201201 (CN); XIA, Zhiqiang, Shanghai 201201 (CN); YANG, Kang, Shanghai 201201 (CN)
(74) Representative: Germain Maureau
(86) International application number: PCT/CN2025/117687
(87) International publication number: WO 2026/137939

(57) **Abstract**

Embodiments of the present application provide a display panel and a display apparatus. The display panel includes a shift register, which includes a plurality of shift register units each including an input module, an output module, and a voltage stabilizing module; the input module is configured to write a voltage to a first node and a second node respectively at least based on an input signal and a first clock signal; and the output module is connected to the first node and the second node respectively, and the output module is configured to output a high-level signal based on the voltage of the first node and further configured to output a low-level signal based on the voltage of the second node; and the voltage stabilizing module is at least connected to the first node, and the voltage stabilizing module is configured to pull up a potential of the first node based on the voltage of the first node and a first voltage signal during at least part of periods when the first node is at a high potential. The present application can ensure that the shift register unit stably outputs a high-level enable signal and improve the reliability of product performance.

## Description

The present application claims priority to Chinese Patent Application No. 202411958860.6, entitled "DISPLAY PANEL AND DISPLAY APPARATUS", filed on December 27, 2024 before China National Intellectual Property Administration, the content of which is incorporated herein by reference in its entirety.

### TECHNICAL FIELD

The present disclosure relates to the field of display technologies, and in particular, to a display panel and a display apparatus.

### BACKGROUND

Indium Gallium Zinc Oxide (IGZO) is a material used for the channel layer in the new-generation thin-film transistor (TFT) technology, and belongs to one type of metal oxide panel technology. IGZO transistors have the advantages of high mobility and low leakage current; in practical applications, they can effectively reduce image retention and also reduce costs. At present, pixel circuits entirely fabricated using metal oxide transistors have become one of the technical development trends; therefore, providing a matching and applicable shift driving circuit is an urgent technical problem to be solved.

### SUMMARY

To solve the problems existing in the prior art, the present disclosure provides a display panel and a display apparatus, so as to provide a shift driving circuit capable of stably outputting scanning signals and improve product yield.

In a first aspect, an embodiment of the present disclosure provides a display panel including a shift register, where the shift register includes a plurality of shift register units each including an input module, an output module, and a voltage stabilizing module;
the input module is configured to write a voltage to a first node and a second node respectively at least based on an input signal and a first clock signal; and the output module is connected to the first node and the second node respectively, and the output module is configured to output a high-level signal based on the voltage of the first node and further configured to output a low-level signal based on the voltage of the second node; and
the voltage stabilizing module is at least connected to the first node, and the voltage stabilizing module is configured to pull up a potential of the first node based on the voltage of the first node and a first voltage signal during at least part of periods when the first node is at a high potential.

In a second aspect, based on the same inventive concept, an embodiment of the present disclosure further provides a display apparatus including the display panel provided in any embodiment of the present disclosure.

The display panel and the display apparatus provided in the embodiments of the present disclosure have the following beneficial effects: the display panel is provided with a plurality of cascaded shift register units, transistors in the shift register unit are n-type transistors, the voltage stabilizing module is added to the shift register unit, the voltage stabilizing module can pull up the potential of the first node in at least part of the period when the first node is at a high potential, so that the first node is stably maintained at the high potential, thereby ensuring that the shift register unit stably outputs a high-level signal, and thus the shift register unit can stably provide a high level enable signal to the n-type transistors in the pixel circuits, which ensures the stable operation of the pixel circuits and improves the reliability of product performance.

### BRIEF DESCRIPTION OF DRAWINGS

To more clearly illustrate the technical solutions in the embodiments of the present disclosure or in the prior art, the drawings required to be used in the description of the embodiments or the prior art will be briefly introduced below. The drawings in the following description are some of the embodiments of the present invention. For those skilled in the art, other drawings can also be obtained based on these drawings without creative efforts.
FIG. 1 is a schematic diagram of a pixel circuit in the relevant technology;
FIG. 2 is a schematic diagram of a shift register unit in the relevant technology;
FIG. 3 is a timing diagram of the shift register unit in the embodiment of FIG. 2;
FIG. 4 is a simplified schematic diagram of a display panel according to an embodiment of the present disclosure;
FIG. 5 is a schematic diagram of a shift register unit according to an embodiment of the present disclosure;
FIG. 6 is a timing diagram according to an embodiment of the present disclosure;
FIG. 7 is a schematic diagram of another shift register unit according to an embodiment of the present disclosure;
FIG. 8 is another timing diagram according to an embodiment of the present disclosure;
FIG. 9 is a schematic diagram of another shift register unit according to an embodiment of the present disclosure;
FIG. 10 is a schematic diagram of another shift register unit according to an embodiment of the present disclosure;
FIG. 11 is a schematic diagram of another shift register unit according to an embodiment of the present disclosure;
FIG. 12 is another timing diagram according to another embodiment of the present disclosure;
FIG. 13 is another timing diagram according to an embodiment of the present disclosure;
FIG. 14 is a schematic diagram of another shift register unit according to an embodiment of the present disclosure;
FIG. 15 is a schematic diagram of another shift register unit according to an embodiment of the present disclosure;
FIG. 16 is a schematic diagram of another shift register unit according to an embodiment of the present disclosure;
FIG. 17 is another timing diagram according to an embodiment of the present disclosure;
FIG. 18 is a schematic diagram of cascading of shift register units according to an embodiment of the present disclosure;
FIG. 19 is a schematic diagram of another shift register unit according to an embodiment of the present disclosure;
FIG. 20 is another schematic diagram of cascading of shift register units according to an embodiment of the present disclosure;
FIG. 21 is a schematic diagram of another shift register unit according to an embodiment of the present disclosure;
FIG. 22 is another timing diagram according to an embodiment of the present disclosure;
FIG. 23 is a schematic diagram of another shift register unit according to an embodiment of the present disclosure;
FIG. 24 is another timing diagram according to an embodiment of the present disclosure;
FIG. 25 is a schematic diagram of another shift register unit according to an embodiment of the present disclosure;
FIG. 26 is a schematic diagram of another shift register unit according to an embodiment of the present disclosure; and
FIG. 27 is a schematic diagram of a display apparatus according to an embodiment of the present disclosure.

### DESCRIPTION OF EMBODIMENTS

To make the objectives, technical solutions and advantages of the embodiments of the present disclosure clearer, the technical solutions in the embodiments of the present disclosure will be described clearly and completely below in conjunction with the accompanying drawings in the embodiments of the present disclosure. Apparently, the described embodiments are some rather than all of the embodiments of the present disclosure. All other embodiments obtained by a person of ordinary skill in the art based on the embodiments of the present disclosure without creative efforts shall fall within the protection scope of the present disclosure.

Various modifications and variations may be made to the present disclosure without departing from the spirit or scope of the present disclosure, which is obvious to a person of ordinary skill in the art. Therefore, the present disclosure intends to cover the modifications and variations of the present disclosure that fall within the scope of the corresponding claims (the claimed technical solutions) and their equivalents. It should be noted that the implementations provided by the embodiments of the present disclosure may be combined with each other without contradiction.

The terms used in the embodiments of the present disclosure are merely for the purpose of describing specific embodiments and are not intended to limit the present disclosure. The singular forms "a/an", "said" and "the" used in the embodiments of the present disclosure and the appended claims are also intended to include the plural forms, unless the context clearly indicates otherwise.

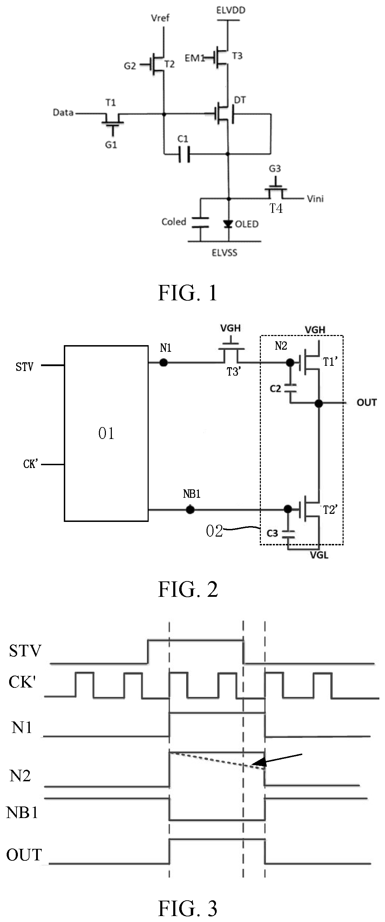

FIG. 1 is a schematic diagram of a pixel circuit in the relevant technology. As shown in FIG. 1, the pixel circuit includes a driving transistor DT, a data writing transistor T1, a gate reset transistor T2, a light-emitting control transistor T3, an electrode reset transistor T4, and a storage capacitor C1. The driving transistor DT is of a dual-gate structure and includes a top gate and a bottom gate; the top gate is connected to the data writing transistor T1, the gate reset transistor T2, and one plate of the storage capacitor C1, and the bottom gate is connected to the other plate of the storage capacitor C1. The operation of the pixel circuit also requires a first power supply signal ELVDD, a reset signal Vref, a constant voltage signal Vini, a data signal Data, a light-emitting control signal EM1, a scan signal G1, a scan signal G2, and a scan signal G3. The pixel circuit is connected to a first electrode of a light-emitting device OLED (Organic Light-Emitting Diode); and a second electrode of the light-emitting device OLED is connected to a second power supply signal ELVSS, and Coled represents a parasitic capacitance of the light-emitting device OLED itself. An active layer of each transistor in the pixel circuit includes a metal oxide, and the transistors are n-type transistors. The enable levels of the control signals for the pixel circuit, such as the light-emitting control signal EM1, the scan signal G1, the scan signal G2, and the scan signal G3, are high levels, and thus a shift register unit capable of providing an active-high enable level is required.

FIG. 2 is a schematic diagram of a shift register unit in the relevant technology. As shown in FIG. 2, the shift register unit includes an input module 01 and an output module 02. The output module 02 includes a first output transistor T1', a second output transistor T2', a second capacitor C2, and a third capacitor C3. Output terminals of the input module 01 are connected to a node N1 and a node NB1; a control terminal of the first output transistor T1' is connected to a node N2, and the node N2 is connected to the node N1 through a switch transistor T3'; and a control terminal of the second output transistor T2' is connected to the node NB1. A first terminal of the first output transistor T1' receives a high-level signal VGH, and a second terminal of the first output transistor T1' is connected to an output terminal OUT of the shift register unit; and a first terminal of the second output transistor T2' receives a low-level signal VGL, and a second terminal of the second output transistor T2' is connected to the output terminal OUT of the shift register unit. A control terminal of the switch transistor T3' receives the high-level signal VGH. The first output transistor T1', the second output transistor T2', and the switch transistor T3' are all n-type transistors. The input module 01 writes signals to the node N1 and the node NB1 respectively under the control of an input signal STV and a clock signal CK'.

FIG. 3 is a timing diagram of the shift register unit in the embodiment of FIG. 2. The potential changes at each node are illustrated in FIG. 3. As shown in FIG. 3, during a period when the node N2 is at a high level, the first output transistor T1' is turned on to provide the high-level signal VGH to the output terminal OUT, and the output terminal OUT outputs the high-level signal; and during a period when the node NB1 is at a high level, the second output transistor T2' is turned on to provide the low-level signal VGL to the output terminal OUT, and the output terminal OUT outputs the low-level signal. Due to the narrow threshold voltage range of n-type transistors, during a period when a high level is written to the node N2, the node N2 leaks current to the node N1 through the switch transistor T3', so that the potential of the node N2 is reduced (as illustrated by the arrow in FIG. 3). The potential change at the node N2 affects the on-state of the first output transistor T1', and in turn affects the capability of outputting the high-level signal. In cases where the high-level signal is used as an enable signal, it affects the operation of a pixel circuit, resulting in abnormal display.

To solve the problems existing in the relevant technologies, an embodiment of the present disclosure provides a display panel. A voltage stabilizing module is provided in the shift register unit, and the voltage stabilizing module is used to stabilize the potentials of the control terminals of the output module, so that the output module stably outputs a high level enable signal. In applications, the shift register unit outputs stable high level enable signals to drive the n-type transistors in the pixel circuit.

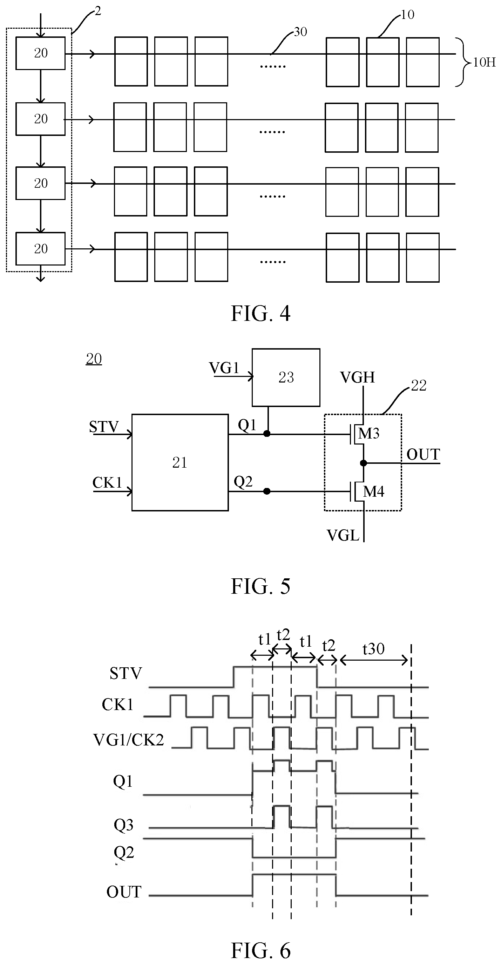

FIG. 4 is a simplified schematic diagram of a display panel according to an embodiment of the present disclosure. As shown in FIG. 4, the display panel includes a plurality of pixel circuits 10 arranged in an array, and the pixel circuits 10 are arranged in pixel circuit rows 10H in a horizontal direction. A plurality of cascaded shift register units 20 form a shift register 2, and output terminals of the shift register units 20 are connected to the pixel circuits 10 in the pixel circuit rows 10H through scan lines 30. The pixel circuit 10 includes at least one n-type transistor, and the output terminal of the shift register unit 20 outputs a high level enable signal to drive the n-type transistors in the pixel circuits 10. In FIG. 4, it is illustrated that the shift register units 20 are provided at one side of the pixel circuit rows 10H, and in some other implementations, the shift register units 20 are provided at both sides of the pixel circuit rows 10H.

FIG. 5 is a schematic diagram of a shift register unit according to an embodiment of the present disclosure. As shown in FIG. 5, the shift register unit includes an input module 21, an output module 22, and a voltage stabilizing module 23. The input module 21 is configured to write a voltage to a first node Q1 and a second node Q2 respectively at least based on an input signal STV and a first clock signal CK1. The output module 22 is connected to the first node Q1 and the second node Q2 respectively; and the output module 22 is configured to output a high-level signal based on a voltage of the first node Q1, and is further configured to output a low-level signal based on a voltage of the second node Q2. Optionally, the output module 22 includes a third output transistor M3 and a fourth output transistor M4, the third output transistor M3 provides a high-level signal VGH to an output terminal OUT under the control of a high level of the first node Q1, and the fourth output transistor M4 provides a low-level signal VGL to the output terminal OUT under the control of a high level of the second node Q2. The high-level signal output by the output terminal OUT serves as an enable signal for driving the n-type transistors in the pixel circuits 10.

The voltage stabilizing module 23 is at least connected to the first node Q1; and during at least part of periods when the first node Q1 is at a high potential, the voltage stabilizing module 23 is configured to pull up the potential of the first node Q1 based on the voltage of the first node Q1 and a first voltage signal VG1. The first voltage signal VG1 is at high-level during at least part of the period.

The embodiment of the present disclosure provides a display panel, in which the voltage stabilizing module 23 is added to the shift register unit 20, and the voltage stabilizing module 23 can pull up the potential of the first node Q1 in at least part of the period when the first node Q1 is at a high potential, so that the first node Q1 is stably maintained at the high potential, thereby ensuring that the shift register unit 20 stably outputs a high-level signal, and thus the shift register unit 20 can stably provide a high level enable signal to the n-type transistors in the pixel circuits 10, which ensures the stable operation of the pixel circuits 10 and improves the reliability of product performance.

In some implementations, the transistor in the output module 22 that is at least connected to the first node Q1 is an n-type transistor. An n-type transistor is turned on under the control of a high level and turned off under the control of a low level. In the embodiment of the present disclosure, the voltage stabilizing module 23 is configured to make the first node Q1 stably maintain a high potential during the period when the first node Q1 is at a high potential, which can ensure that the n-type transistor in the output module 22 maintains a stable on-state, thereby enabling the shift register unit 20 to stably output a high-level signal. Optionally, all transistors in the output module 22 are n-type transistors.

In some implementations, all transistors in the shift register unit 20 are n-type transistors. Such a setting enables the active layer of each transistor to be fabricated using the same material, which can simplify the film layer manufacturing process of the display panel and reduce manufacturing costs. Additionally, when at least some transistors in the pixel circuits of the display panel are fabricated as n-type transistors, the shift register unit 20 can match the manufacturing process of the pixel circuits to simplify the manufacturing process of the display panel.

In embodiments of the present disclosure, the active layer of the n-type transistor in the shift register unit 20 includes indium gallium zinc oxide. Indium gallium zinc oxide transistors have the advantages of high mobility and low leakage current, which can improve the performance reliability of the shift register unit 20.

In some implementations, FIG. 6 is a timing diagram according to an embodiment of the present disclosure, which can be used to drive the shift register unit 20 provided in FIG. 5. As shown in FIG. 6, an operation of the shift register unit 20 includes a first period t1 and a second period t2; and the first node Q1 is at a high potential at least during the first period t1 and the second period t2. During the first period t1, the voltage of the first node Q1 is V1; and during the second period t2, the voltage of the first node Q1 is V2, where V2>V1. As can be seen from the timing diagram in FIG. 6, the potential of the first node Q1 during the second period t2 is higher than the potential of the first node Q1 during the first period t1. In these implementations, the voltage stabilizing module 23 pulls the potential of the first node Q1 even higher during the second period t2, enabling the first node Q1 to stably maintain a high potential, which in turn can ensure that the shift register unit 20 stably outputs a high-level signal, and thus the shift register unit 20 can provide a stable high level enable signal to the n-type transistors in the pixel circuits 10, thereby ensuring the stable operation of the pixel circuits 10 and improving the reliability of product performance.

In some implementations, an operation of the shift register unit 20 includes m first periods t1 and m second periods t2, where m is an integer and m≥1; and in chronological order, the first periods t1 and the second periods t2 are arranged alternately, and a first one of the first periods t1 is earlier than a first one of the second periods t2. The embodiment in FIG. 6 takes m=2 as an example. It can be understood that the number m is related to the duration for which the first node Q1 is maintained at a high potential; and the larger m is, the longer the duration for which the first node Q1 is maintained at a high potential. The writing of the potential of the first node Q1 is controlled by the input module 21, that is, the duration for which the first node Q1 is maintained at a high potential is related to the duration of the high level of the input signal STV; and the longer the duration for which the first node Q1 is maintained at a high potential, the longer the duration for which the shift register unit 20 outputs a high-level signal. In the embodiment of the present disclosure, the number m is set according to the required duration of the active-high enable level in applications.

In some implementations, during the first period t1, the input module 21 writes a high potential to the first node Q1 based on a high-level signal of the first clock signal CK1, and the voltage stabilizing module 23 writes, under the control of the first node Q1, a low-level signal of the first voltage signal VG1 to a third node Q3 in the voltage stabilizing module 23. During the second period t2, the voltage stabilizing module 23 writes a high-level signal of the first voltage signal VG1 to the third node Q3 under the control of the first node Q1, and pulls up the potential of the first node Q1 based on a potential change at the third node Q3. In these implementations, the third node Q3 is provided in the voltage stabilizing module 23, a low level is written to the third node Q3 during the first period t1, a high level is written to the third node Q3 during the second period t2, and the potential change at the third node Q3 is used to pull up the potential of the first node Q1. Even if there is leakage current from the first node Q1 to other nodes, the leakage current can be compensated for, ensuring that the first node Q1 has a relatively stable high potential, enabling the output transistor controlled by the first node Q1 to be in stable on-state, which in turn can ensure that the shift register unit 20 stably outputs a high-level signal. Consequently, the shift register unit 20 can provide a stable high level enable signal to the n-type transistors in the pixel circuits 10, ensuring the stable operation of the pixel circuits 10 and improving the reliability of product performance.

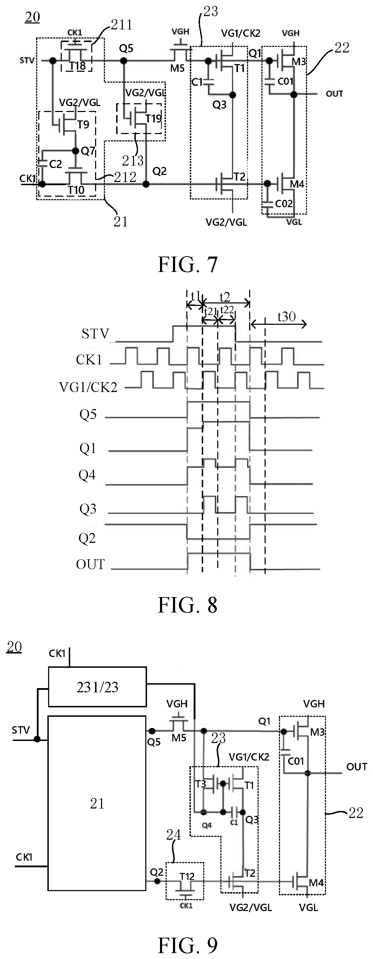

In some implementations, FIG. 7 is a schematic diagram of another shift register unit according to an embodiment of the present disclosure. As shown in FIG. 7, the voltage stabilizing module 23 includes a first transistor T1, a second transistor T2, and a first capacitor C1; a control terminal of the first transistor T1 is connected to the first node Q1, a control terminal of the second transistor T2 is connected to the second node Q2, a first terminal of the first transistor T1 receives the first voltage signal VG1, a second terminal of the first transistor T1 and a second terminal of the second transistor T2 are connected to a third node Q3, and a first terminal of the second transistor T2 receives a second voltage signal VG2. One plate of the first capacitor C1 is connected to the first node Q1, and the other plate of the first capacitor C1 is connected to the third node Q3. In addition, the shift register unit 20 further includes a protection transistor M5, a control terminal of the protection transistor M5 receives the high-level signal VGH, the protection transistor M5 is connected between one output terminal of the input module 21 and the first node Q1, and the protection transistor M5 is connected to the one output terminal of the input module 21 at a fifth node Q5.

In conjunction with the timing diagram illustrated in FIG. 6, during the first period t1, the voltage stabilizing module 23 writes the low-level signal of the first voltage signal VG1 to the third node Q3 under the control of the high potential of the first node Q1. For example, the high potential of the first node Q1 controls the first transistor T1 to be turned on, so as to write the low-level signal of the first voltage signal VG1 to the third node Q3. During this period, the third node Q3 is at a low potential, and thus a plate of the first capacitor C1 connected to the first node Q1 is at a high potential, and the other plate of the first capacitor C1 connected to the third node Q3 is at a low potential.

During the second period t2, the voltage stabilizing module 23 writes the high-level signal of the first voltage signal VG1 to the third node Q3 under the control of the high potential of the first node Q1. For example, the high potential of the first node Q1 controls the first transistor T1 to be turned on, so as to write the high-level signal of the first voltage signal VG1 to the third node Q3, so that the third node Q3 is at a high potential. The potential of the third node Q3 jumps from low to high, and due to the coupling effect of the first capacitor C1, the potential of the first node Q1 is pulled up.

In this implementation, the voltage stabilizing module 23 operates under the control of the potential of the first node Q1, and pulls up the potential of the first node Q1 by utilizing the coupling effect of the first capacitor C1, so that the potential of the first node Q1, after being pulled up during the second period t2, can be higher than the potential of the first node Q1 during the first period t1. The leakage current from the first node Q1 to the fifth node Q5 through the protection transistor M5 can be compensated for, ensuring that the first node Q1 is stably maintained at a high potential, thereby enabling the output transistor controlled by the first node Q1 to be stably in on-state, and further ensuring that the output terminal of the shift register unit 20 outputs a stable high-level enable signal.

In some implementations, as shown in FIG. 6, the operation of the shift register unit 20 further includes a reset period t30; during the reset period t30, the first node Q1 is at a low potential, and the second node Q2 is at a high potential. During the reset period t30, the voltage stabilizing module 23 writes the low potential of the second voltage signal VG2 to the third node Q3 under the control of the second node Q2. This enables the reset of the third node Q3. For example, in conjunction with FIG. 7, during the period when the second node Q2 is at a high level, the second node Q2 controls to turn on the second transistor T2, so as to write the second voltage signal VG2 to the third node Q3 for resetting the third node Q3. Optionally, the second voltage signal VG2 is a low-level signal VGL.

The structure of the output module 22 is also illustrated in FIG. 7. The output module 22 includes a third output transistor M3, a fourth output transistor M4, a capacitor C01, and a capacitor C02. A control terminal of the third output transistor M3 is connected to the first node Q1, a first terminal of the third output transistor M3 receives the high-level signal VGH, and a second terminal of the third output transistor M3 is connected to the output terminal OUT of the output module 22; and a control terminal of the fourth output transistor M4 is connected to the second node Q2, a first terminal of the fourth output transistor M4 receives the low-level signal VGL, and a second terminal of the fourth output transistor M4 is connected to the output terminal OUT of the output module 22. During the period when the first node Q1 is at a high level, the first node Q1 controls the third output transistor M3 to be turned on, and the shift register unit outputs a high-level signal. During the period when the second node Q2 is at a high level, the second node Q2 controls the fourth output transistor M4 to be turned on, and the shift register unit outputs a low-level signal.

In some implementations, the first voltage signal VG1 is a second clock signal CK2. The first clock signal CK1 and the second clock signal CK2 may be a pair of clock signals with the same period. During the first period t1, the first clock signal CK1 is at a high level, and the second clock signal CK2 is at a low level; and during the second period t2, the first clock signal CK1 is at a low level, and the second clock signal CK2 is at a high level. The first clock signal CK1 and the second clock signal CK2 jointly drive the plurality of cascaded shift register units 20. In the embodiment of the present disclosure, setting the first voltage signal VG1 as the second clock signal CK2 can simplify the types of signals required to drive the shift register units 20, and is also beneficial to reducing the wiring of the display panel and narrowing the bezel.

In some other implementations, FIG. 8 is another timing diagram according to an embodiment of the present disclosure, which can be used to drive the shift register unit 20 according to the present disclosure. As shown in FIG. 8, an operation of the shift register unit 20 includes a first period t1 and a second period t2; and the first node Q1 is at the high potential at least during the first period t1 and the second period t2. During the first period t1, the voltage of the first node Q1 is V1; and during the second period t2, the voltage of the first node Q1 is V2, where V2>V1. In chronological order, the first period t1 is earlier than the second period t2; a length of the first period t1 is t01, and a length of the second period t2 is t02, where t02>t01. That is, the duration of the first period t1 is shorter than the duration of the second period t2, and the first node Q1 remains at a higher potential for a longer time after its potential is pulled up. Moreover, the high potential of the first node Q1 controls the output module 22 to output a high-level enable signal; and the longer the first node Q1 remains at a higher potential, the better the stability of the high-level signal output by the shift register unit.

In some implementations, during the first period t1, the input module 21 writes a high potential to the first node Q1 based on a high-level signal of the first clock signal CK1, and the voltage stabilizing module 23 writes a high level of the input signal STV to a fourth node Q4 in the voltage stabilizing module 23 under the control of the high-level signal of the first clock signal CK1, and writes a low-level signal of the first voltage signal VG1 to a third node Q3 under the control of a high potential of the fourth node Q4.

The second period t2 includes a first sub-period t21 and a second sub-period t22. During the first sub-period t21, the voltage stabilizing module 23 writes a high-level signal of the first voltage signal VG1 to the third node Q3 under the control of the fourth node Q4, and pulls up the potential of the fourth node Q4 based on a potential change at the third node Q3. A voltage of the fourth node Q4 is V3; the voltage of the fourth node Q4 is written to the first node Q1 via a unidirectional conduction between the fourth node Q4 and the first node Q1. During the second sub-period t22, the voltage stabilizing module 23 writes the low-level signal of the first voltage signal VG1 to the third node Q3 under the control of the high potential of the fourth node Q4, and writes a voltage of the input signal STV to the fourth node Q4 under the control of the high level of the first clock signal CK1. A voltage of the fourth node Q4 is V4, and V4<V3. Due to the unidirectional conduction between the fourth node Q4 and the first node Q1, the first node Q1 will not leak current to the fourth node Q4, enabling the first node Q1 to be maintained at a high potential. As can be seen from the timing of FIG. 8, during the second period t2, the first node Q1 is maintained at a relatively higher potential, while the fourth node Q4 is maintained at a high potential but with fluctuations in its high potential.

In this implementation, the voltage stabilizing module 23 is provided with the third node Q3 and the fourth node Q4, and a low-level signal is written to the third node Q3 during the first period t1. During the first sub-period t21 of the second period t2, a high-level is written to the third node Q3; and the potential of the fourth node Q4 is pulled up by the potential change at the third node Q3, and then the potential of the first node Q1 is pulled up by the high potential of the fourth node Q4. And during the second sub-period t22, the potential of the fourth node Q4 is pulled down, and the path between the fourth node Q4 and the first node Q1 is cut off. Therefore, it can be ensured that the first node Q1 is stably maintained at a relatively higher high potential after the first sub-period t21, thereby enabling the output transistor controlled by the first node Q1 to be stably in on-state and ensuring that the output terminal of the shift register unit 20 outputs a stable high-level enable signal.

In some implementations, FIG. 9 is a schematic diagram of another shift register unit according to an embodiment of the present disclosure. As shown in FIG. 9, the voltage stabilizing module 23 includes a first transistor T1, a second transistor T2, a first capacitor C1, a third transistor T3, and an input sub-module 231. A control terminal of the first transistor T1 is connected to the first node Q1 through the third transistor T3, a control terminal of the second transistor T2 is connected to the second node Q2, a first terminal of the first transistor T1 receives the first voltage signal VG1, a second terminal of the first transistor T1 and a second terminal of the second transistor T2 are connected to a third node Q3, and a first terminal of the second transistor T2 receives a second voltage signal VG2. The first voltage signal VG1 may be a second clock signal CK2, and the second voltage signal VG2 may be the low-level signal VGL. The control terminal of the first transistor T1, one plate of the first capacitor C1, and a control terminal of the third transistor T3 are connected to a fourth node Q4, a first terminal of the third transistor T3 is connected to the fourth node Q4, and a second terminal of the third transistor T3 is connected to the first node Q1. An output terminal of the input sub-module 231 is connected to the fourth node Q4, and the input sub-module 231 is configured to write a voltage to the fourth node Q4 based on the input signal STV and the first clock signal CK1.

In conjunction with the timing diagram in FIG. 8, during the first period t1, the input sub-module 231 writes, under the control of the first clock signal CK1, the high level of the input signal STV to the fourth node Q4 in the voltage stabilizing module 23. The high potential of the fourth node Q4 controls the first transistor T1 to be turned on, so as to write the low-level signal of the first voltage signal VG1 to the third node Q3. During the first sub-period t21 of the second period t2, the high potential of the fourth node Q4 controls the first transistor T1 to be turned on, so as to write the high-level signal of the first voltage signal VG1 to the third node Q3. The third node Q3 jumps from a low potential to a high potential, and due to the coupling effect of the first capacitor C1, the potential of the fourth node Q4 is pulled up. Moreover, the high potential of the fourth node Q4 controls the third transistor T3 to be turned on, so as to write the high potential of the fourth node Q4 to the first node Q1, thereby enabling the potential of the first node Q1 to be pulled up. In addition, in the embodiment of FIG. 9, both the control terminal and the first terminal of the third transistor T3 are connected to the fourth node Q4, so the third transistor T3 forms a diode-like structure, enabling it to have the characteristic of unidirectional conduction. During the second sub-period t22, the low-level signal of the first voltage signal VG1 is written to the third node Q3 under the control of the high potential of the fourth node Q4, and the voltage stabilizing module 23 writes the high level of the input signal STV to the fourth node Q4 under the control of the high-level signal of the first clock signal CK1. During this period, the potential of the fourth node Q4 is lower than the potential of the fourth node Q4 in the first sub-period t21. However, due to the diode-like structure formed by the third transistor T3 that can prevent the first node Q1 from discharging to the fourth node Q4, the high potential of the first node Q1 is more stable. Therefore, the first node Q1 can still be maintained at a relatively higher high potential in the second sub-period t22.

In addition, in the embodiment of FIG. 9, the operation of the shift register unit 20 further includes a reset period t30; during the reset period t30, the first node Q1 is at a low potential, and the second node Q2 is at a high potential. During the reset period t30, the voltage stabilizing module 23 writes the low potential of the second voltage signal VG2 to the third node Q3 under the control of the second node Q2. For example, during the period when the second node Q2 is at a high level, the second node Q2 controls the second transistor T2 to be turned on, so as to write the second voltage signal VG2 to the third node Q3 for resetting the third node Q3.

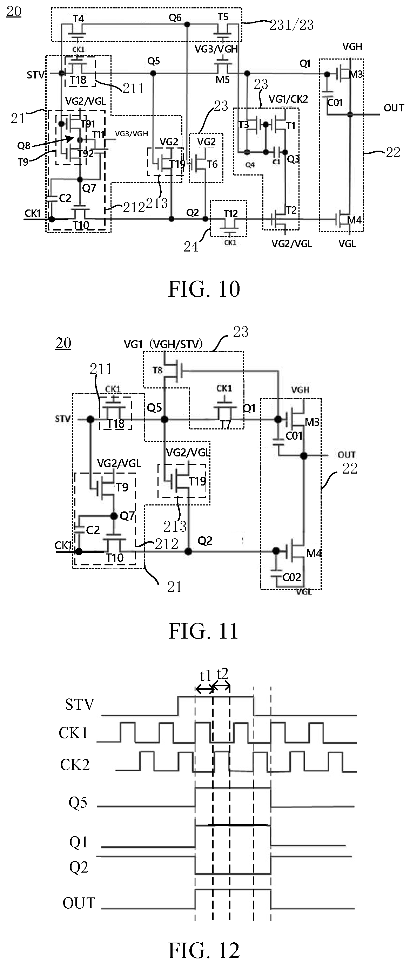

In some implementations, FIG. 10 is a schematic diagram of another shift register unit according to an embodiment of the present disclosure. As shown in FIG. 10, the input sub-module 231 includes a fourth transistor T4 and a fifth transistor T5. A control terminal of the fourth transistor T4 receives the first clock signal CK1, a first terminal of the fourth transistor T4 receives the input signal STV, a second terminal of the fourth transistor T4 is connected to a sixth node Q6, a control terminal of the fifth transistor T5 receives a third voltage signal VG3, a first terminal of the fifth transistor T5 is connected to the sixth node Q6, and a second terminal of the fifth transistor T5 is connected to the fourth node Q4. The third voltage signal VG3 is the high-level signal VGH. During the first period t1, the fourth transistor T4 is turned on under the control of the high level of the first clock signal CK1, so as to write the high level of the input signal STV to the sixth node Q6; and the fifth transistor T5 is turned on under the control of the third voltage signal VG3, so as to write the high potential of the sixth node Q6 to the fourth node Q4. In the first sub-period t21 of the second period t2, the first clock signal CK1 is at a low level, the fourth transistor T4 is turned off, and the path through which the input sub-module 231 writes a signal to the fourth node Q4 is disabled, enabling the fourth node Q4 to be maintained at a high potential. During the second sub-period t22 of the second period t2, the first clock signal CK1 is at a high level, the fourth transistor T4 is turned on, and the input sub-module 231 writes the signal provided by the input signal STV to the fourth node Q4.

In some implementations, as shown in FIG. 10, the voltage stabilizing module 23 further includes a sixth transistor T6. A control terminal of the sixth transistor T6 is connected to the sixth node Q6, a first terminal of the sixth transistor T6 receives the second voltage signal VG2, and a second terminal of the sixth transistor T6 is connected to the second node Q2. During the first period t1 and the second period t2 when the first node Q1 is at a high potential, the sixth node Q6 is at a high potential; and the high potential of the sixth node Q6 controls the sixth transistor T6 to be turned on, so as to write the low-level of the second voltage signal VG2 to the second node Q2, enabling the second node Q2 to be well maintained at a low-level.

In some other implementations, FIG. 11 is a schematic diagram of another shift register unit according to an embodiment of the present disclosure, FIG. 12 is another timing diagram according to an embodiment of the present disclosure, and the signal timing provided in FIG. 12 can be used to drive the shift register unit provided in FIG. 11. As shown in FIG. 11, the voltage stabilizing module 23 includes a seventh transistor T7 and an eighth transistor T8. A control terminal of the seventh transistor T7 receives the first clock signal CK1, a first terminal of the seventh transistor T7 and one output terminal of the input module 21 are connected to a fifth node Q5, and a second terminal of the seventh transistor T7 is connected to the first node Q1. A control terminal of the eighth transistor T8 is connected to the first node Q1; a first terminal of the eighth transistor T8 receives the first voltage signal VG1, where the first voltage signal VG1 is the input signal STV or the high-level signal VGH; and a second terminal of the eighth transistor T8 is connected to the fifth node Q5.

In conjunction with the timing diagram illustrated in FIG. 12, an operation of the shift register unit 20 includes a first period t1 and a second period t2; and the first node Q1 is at a high potential during the first period t1 and the second period t2.

During the first period t1, the first clock signal CK1 is at high-level and the first voltage signal VG1 is at high-level. The voltage stabilizing module 23 writes the high-level signal of the first voltage signal VG1 to the fifth node Q5 under the control of the potential of the first node Q1, and writes the high potential of the fifth node Q5 to the first node Q1 under the control of the high-level signal of the first clock signal CK1. For example, the high potential of the first node Q1 controls the eighth transistor T8 to be turned on, so as to write the high-level signal VGH (or the high-level signal of the input signal STV) to the fifth node Q5; and the high-level signal of the first clock signal CK1 controls the seventh transistor T7 to be turned on, so as to write the high potential of the fifth node Q5 to the first node Q1. During this period, both the first node Q1 and the fifth node Q5 are at a high potential.

During the second period t2, the first clock signal CK1 is at low-level and the first voltage signal VG1 is at high-level. The voltage stabilizing module 23 writes the high-level signal of the first voltage signal VG1 to the fifth node Q5 under the control of the potential of the first node Q1, and cuts off the path between the fifth node Q5 and the first node Q1 under the control of the low-level signal of the first clock signal CK1. For example, the high potential of the first node Q1 controls the eighth transistor T8 to be turned on, so as to write the high-level signal VGH (or the high-level signal of the input signal STV) to the fifth node Q5; meanwhile, since the first clock signal CK1 is at low-level, the seventh transistor T7 is turned off. During this period, both the first node Q1 and the fifth node Q5 are at a high potential, and the path between the two nodes is cut off, which enables the first node Q1 to be maintained at a high potential and prevents the first node Q1 from leaking current to other nodes, thereby avoiding impacts on the output of the high-level signal of the shift register unit.

In some implementations, as shown in FIG. 7, the input module 21 includes a first sub-module 211, a second sub-module 212, and a third sub-module 213. The first sub-module 211 is configured to write a voltage to the first node Q1 based on the input signal STV and the first clock signal CK1; the second sub-module 212 is configured to write a high level to the second node Q2 at least based on the input signal STV and the first clock signal CK1; and the third sub-module 213 is configured to write a low level to the second node Q2 under the control of an output signal of the first sub-module 211. In these implementations, the first sub-module 211, the second sub-module 212, and the third sub-module 213 cooperate to write signals to the first node Q1 and the second node Q2.

It is illustrated in FIG. 7 that the shift register unit 20 further includes a protection transistor M5, where one output terminal of the input module 21 is connected to the fifth node Q5, and the protection transistor M5 is connected between the fifth node Q5 and the first node Q1. The first sub-module 211 is then configured to write a voltage to the fifth node Q5 based on the input signal STV and the first clock signal CK1, and in turn writes a voltage to the first node Q1 through the protection transistor M5.

In one embodiment, as shown in FIG. 7, the second sub-module 212 includes a ninth transistor T9, a tenth transistor T10, and a second capacitor C2. A control terminal of the ninth transistor T9 receives the input signal STV; a first terminal of the ninth transistor T9 receives a second voltage signal VG2, where the second voltage signal VG2 may be the low-level signal VGL; and a second terminal of the ninth transistor T9 is connected to a control terminal of the tenth transistor T10 at a seventh node Q7. A first terminal of the tenth transistor T10 receives the first clock signal CK1, and a second terminal thereof is connected to the second node Q2; and one plate of the second capacitor C2 receives the first clock signal CK1, and the other plate thereof is connected to the seventh node Q7.

The first sub-module 211 includes an eighteenth transistor T18. A control terminal of the eighteenth transistor T18 receives the first clock signal CK1, a first terminal of the eighteenth transistor T18 receives the input signal STV, and a second terminal thereof is connected to the first node Q1. The third sub-module 213 includes a nineteenth transistor T19. A control terminal of the nineteenth transistor T19 is connected to an output terminal of the first sub-module 211 (i.e., connected to the fifth node Q5), a first terminal of the nineteenth transistor T19 receives a second voltage signal VG2, and a second terminal of the nineteenth transistor T19 is connected to the second node Q2.

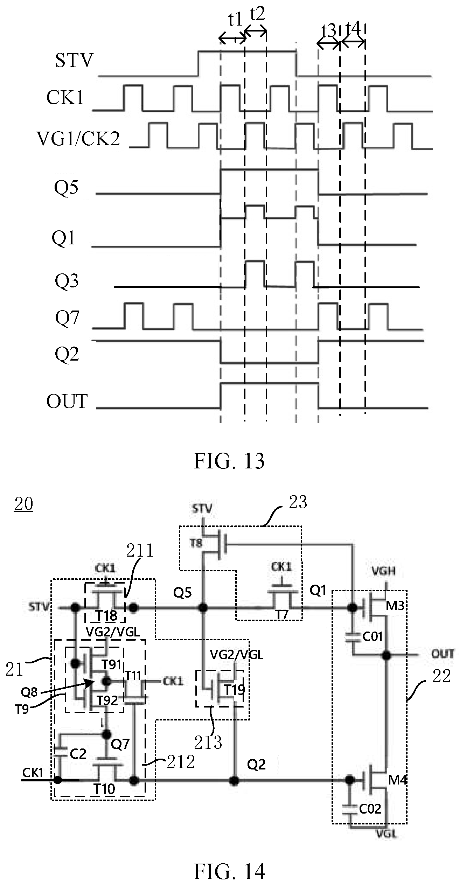

FIG. 13 is another timing diagram according to an embodiment of the present disclosure, which can be used to drive the shift register unit provided by the embodiment of FIG. 7. The operation of the input module 21 can be understood in conjunction with FIG. 7 and FIG. 13, and an operation of the shift register unit 20 includes a first period t1, a second period t2 and a third period t3 in chronological order.

During the first period t1, the input module 21 is turned on under the control of the high-level signal of the first clock signal CK1 and the high level of the input signal STV, so as to write the high level of the input signal STV to the first node Q1, and write the low level of the second voltage signal VG2 to the second node Q2 and the seventh node Q7. For example, the high-level signal of the first clock signal CK1 controls the eighteenth transistor T18 in the first sub-module 211 to be turned on, so as to write the high level of the input signal STV to the fifth node Q5; and the high potential of the fifth node Q5 is written to the first node Q1 through the protection transistor M5. The high potential of the fifth node Q5 controls the nineteenth transistor T19 in the third sub-module 213 to be turned on, so as to write the low level of the second voltage signal VG2 to the second node Q2. In addition, the high level of the input signal STV controls the ninth transistor T9 in the second sub-module 212 to be turned on, so as to write the low level of the second voltage signal VG2 to the seventh node Q7. During this period, the fifth node Q5 and the first node Q1 are at a high potential, and the second node Q2 and the seventh node Q7 are at a low potential.

During the second period t2, the input module 21 is turned off under the control of the low-level signal of the first clock signal CK1; the first node Q1 is maintained at a high potential, and the second node Q2 and the seventh node Q7 are maintained at a low potential. For example, the low-level signal of the first clock signal CK1 controls the eighteenth transistor T18 to be turned off, so the fifth node Q5 is maintained at a high potential. The high potential of the fifth node Q5 controls the nineteenth transistor T19 in the third sub-module 213 to be turned on, so the second node Q2 is maintained at a low potential. The high level of the input signal STV controls the ninth transistor T9 in the second sub-module 212 to be turned on, so the seventh node Q7 is maintained at a low potential. As can be seen from the above description for the voltage stabilizing module 23, during this period, the first node Q1 is maintained at a high potential due to the action of the voltage stabilizing module 23.

During the third period t3, the input module 21 is turned on under the control of the high-level signal of the first clock signal CK1, so as to write the low level of the input signal STV to the first node Q1, pull up the potential of the seventh node Q7 based on the high-level of the first clock signal CK1, and write the high level of the first clock signal CK1 to the second node Q2. For example, the high-level signal of the first clock signal CK1 controls the eighteenth transistor T18 in the first sub-module 211 to be turned on, so as to write the low level of the input signal STV to the fifth node Q5; and the low potential of the fifth node Q5 is written to the first node Q1 through the protection transistor M5, so that the first node Q1 is at a low potential. In addition, the low level of the input signal STV controls the ninth transistor T9 in the second sub-module 212 to be turned off; and during this period, the first clock signal CK1 jumps from a low level to a high level, and the potential of the seventh node Q7 is pulled up due to the coupling effect of the second capacitor C2, so the seventh node Q7 is at a high potential. The high potential of the seventh node Q7 controls the tenth transistor T10 in the second sub-module 212 to be turned on, so as to write the high-level signal of the first clock signal CK1 to the second node Q2. During this period, the first node Q1 is at a low potential, and the second node Q2 is at a high potential.

In addition, the structure of the input module 21 illustrated in the embodiment of FIG. 11 is the same as the structure of the input module 21 of the input module 21 in FIG. 7, and the operation process of the input module 21 illustrated in the embodiment of FIG. 11 can be understood with reference to the above description, and will not be repeated here.

In some other implementations, as shown in FIG. 10, the input module 21 includes a first sub-module 211, a second sub-module 212, and a third sub-module 213. The first sub-module 211 is configured to write a voltage to the first node Q1 based on the input signal STV and the first clock signal CK1; the second sub-module 212 is configured to write a high level to the second node Q2 at least based on the input signal STV and the first clock signal CK1; and the third sub-module 213 is configured to write a low level to the second node Q2 under the control of an output signal of the first sub-module 211.

The second sub-module 212 includes a ninth transistor T9, a tenth transistor T10, and a second capacitor C2. The ninth transistor T9 includes a first sub-transistor T91 and a second sub-transistor T92, a control terminal of the first sub-transistor T91 and a control terminal of the second sub-transistor T92 receive the input signal STV, a first terminal of the first sub-transistor T91 receives the second voltage signal VG2, a second terminal of the first sub-transistor T91 and a first terminal of the second sub-transistor T92 are connected to an eighth node Q8, and a second terminal of the second sub-transistor T92 is connected to the seventh node Q7. A control terminal of the tenth transistor T10 is connected to a seventh node Q7, a first terminal of the tenth transistor T10 receives the first clock signal CK1, and a second terminal of the tenth transistor T10 is connected to the second node Q2; and one plate of the second capacitor C2 receives the first clock signal CK1, and the other plate of the second capacitor C2 is connected to the seventh node Q7. The second sub-module 212 further includes an eleventh transistor T11, a control terminal of the eleventh transistor T11 is connected to the seventh node Q7, a first terminal of the eleventh transistor T11 receives a third voltage signal VG3, and a second terminal of the eleventh transistor T11 is connected to the eighth node Q8. The second voltage signal VG2 may be the low-level signal VGL, and the third voltage signal VG3 may be the high-level signal VGH. In FIG. 10, it is further illustrated that the first sub-module 211 includes an eighteenth transistor T18, and the third sub-module 213 includes a nineteenth transistor T19.

In another embodiment, FIG. 14 is a schematic diagram of another shift register unit according to an embodiment of the present disclosure. As shown in FIG. 14, the input module 21 includes a first sub-module 211, a second sub-module 212, and a third sub-module 213. The first sub-module 211 includes an eighteenth transistor T18, and the third sub-module 213 includes a nineteenth transistor T19. The second sub-module 212 includes a ninth transistor T9, a tenth transistor T10, and a second capacitor C2. The difference between the input module 21 in the embodiments of FIG. 14 and FIG. 10 lies in that the first terminal of the eleventh transistor T11 in the embodiment of FIG. 14 receives the first clock signal CK1, and the control terminal of the eleventh transistor T11 is connected to the second terminal of the tenth transistor T10.

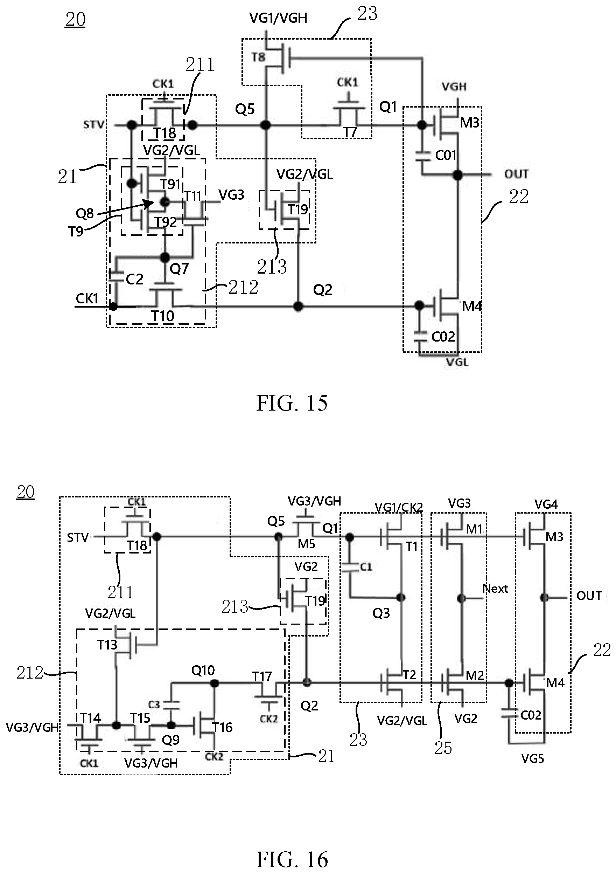

In another embodiment, FIG. 15 is a schematic diagram of another shift register unit according to an embodiment of the present disclosure, and the difference between FIG. 15 and FIG. 14 lies in that in the embodiment of FIG. 15, the first terminal of the eleventh transistor T11 receives the third voltage signal VG3, and the control terminal of the eleventh transistor T11 is connected to the seventh node Q7.

The operation processes of the input module 21 in the above embodiments of FIG. 10, FIG. 14, and FIG. 15 can all be understood in conjunction with the timing diagram provided in FIG. 13 above. For the operation process of the second sub-module 212, take the embodiment of FIG. 10 as an example: during the first period t1, the input signal STV is at a high level, which controls the first sub-transistor T91 and the second sub-transistor T92 to be turned on. Low levels are written to the eighth node Q8 and the seventh node Q7, and the low level of the seventh node Q7 controls the eleventh transistor T11 to be turned off; during the second period t2, the eighth node Q8 and the seventh node Q7 are maintained at a low level; and during the third period t3, the input signal STV is at a low level, which controls the first sub-transistor T91 and the second sub-transistor T92 to be turned off. The first clock signal CK1 jumps from a low level to a high level, and the potential of the seventh node Q7 is pulled up due to the coupling effect of the second capacitor C2. The high potential of the seventh node Q7 controls the eleventh transistor T11 to be turned on, so as to write the high level of the third voltage signal VG3 to the eighth node Q8. During this period, both the eighth node Q8 and the seventh node Q7 are at a high level, and both the first sub-transistor T91 and the second sub-transistor T92 are in an off state. This prevents leakage current from the seventh node Q7 when the ninth transistor T9 is in a negatively biased state. This ensures that the tenth transistor T10 remains in a stable on state, enabling the high-level signal provided by the first clock signal CK1 to be stably written to the second node Q2, so that the second node Q2 is maintained at a stable high potential.

In some implementations, as shown in FIG. 9 and FIG. 10, the shift register unit further includes a leakage prevention module 24 connected between the second node Q2 and the output module 22. The leakage prevention module 24 is configured to be turned off under the control of the first clock signal CK1. Taking FIG. 10 as an example and viewed in conjunction with the timing diagram in FIG. 13: during the third period t3, the first clock signal CK1 is at a high level, a high potential is written to the second node Q2, and then the leakage prevention module 24 is turned on, so as to write the high level of the second node Q2 to the control terminal of the fourth output transistor M4 in the output module 22. This enables the shift register unit to output the low level provided by the low-level signal VGL. The third period t3 is thus the period during which a high-level signal is written to the control terminal of the fourth output transistor M4. During the fourth period t4, the first clock signal CK1 is at a low level, and the leakage prevention module 24 is turned off, whereby the leakage current path at the control terminal of the fourth output transistor M4 is disabled, thereby being capable of stabilizing the potential of the output terminal of the fourth output transistor M4 and allowing the shift register unit to stably output the low-level signal.

As shown in FIG. 10, the leakage prevention module 24 includes a twelfth transistor T12, a control terminal of the twelfth transistor T12 receives the first clock signal CK1, a first terminal of the twelfth transistor T12 is connected to the second node Q2, and a second terminal of the twelfth transistor T12 is connected to one control terminal of the output module 22, for example, the second terminal of the twelfth transistor T12 is connected to the control terminal of the fourth output transistor M4.

In some implementations, FIG. 16 is a schematic diagram of another shift register unit according to an embodiment of the present disclosure. As shown in FIG. 16, the input module 21 includes a first sub-module 211, a second sub-module 212, and a third sub-module 213. The first sub-module 211 is configured to write a voltage to the first node Q1 based on the input signal STV and the first clock signal CK1. The second sub-module 212 is configured to write a voltage to the second node Q2 at least based on an output signal of the first sub-module 211, the first clock signal CK1, and a second clock signal CK2. The third sub-module 213 is configured to write a low level to the second node Q2 under the control of the output signal of the first sub-module 211.

As shown in FIG. 16, the second sub-module 212 includes a thirteenth transistor T13, a fourteenth transistor T14, a fifteenth transistor T15, a sixteenth transistor T16, a seventeenth transistor T17, and a third capacitor C3. A control terminal of the thirteenth transistor T13 is connected to an output terminal of the first sub-module 211, a first terminal of the thirteenth transistor T13 receives a second voltage signal VG2, and a second terminal of the thirteenth transistor T13 is connected to a second terminal of the fourteenth transistor T14. Optionally, the second voltage signal VG2 is the low-level signal VGL. A control terminal of the fourteenth transistor T14 receives the first clock signal CK1, and a control terminal of the fifteenth transistor T15 receives a third voltage signal VG3. Optionally, the third voltage signal VG3 is the high-level signal VGH. A first terminal of the fourteenth transistor T14 receives the third voltage signal VG3, the second terminal of the fourteenth transistor T14 is connected to a first terminal of the fifteenth transistor T15; and a second terminal of the fifteenth transistor T15 and a control terminal of the sixteenth transistor T16 are connected to a ninth node Q9. A first terminal of the sixteenth transistor T16 receives the second clock signal CK2, a second terminal of the sixteenth transistor T16 is connected to a tenth node Q10, one plate of the third capacitor C3 is connected to the ninth node Q9, and the other plate of the third capacitor C3 is connected to a tenth node Q10. A control terminal of the seventeenth transistor T17 receives the second clock signal CK2, a first terminal of the seventeenth transistor T17 is connected to the tenth node Q10, and a second terminal of the seventeenth transistor T17 is connected to the second node Q2.

In addition, the first sub-module 211 includes an eighteenth transistor T18, a control terminal of the eighteenth transistor T18 receives the first clock signal CK1, a first terminal of the eighteenth transistor T18 receives the input signal STV, and a second terminal of the eighteenth transistor T18 is connected to the first node Q1. Optionally, FIG. 16 illustrates that the second terminal of the eighteenth transistor T18 is connected to the fifth node Q5, and the fifth node Q5 is connected to the first node Q1 through the protection transistor M5. The third sub-module 213 includes a nineteenth transistor T19, a control terminal of the nineteenth transistor T19 is connected to an output terminal of the first sub-module 211, a first terminal of the nineteenth transistor T19 receives a second voltage signal VG2, and a second terminal of the nineteenth transistor T19 is connected to the second node Q2.

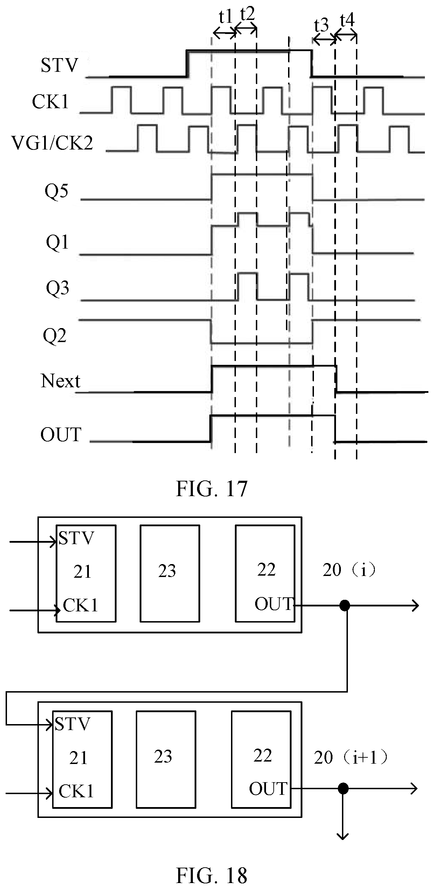

FIG. 17 is another timing diagram according to an embodiment of the present disclosure, which can be used to drive the shift register unit provided in the embodiment of FIG. 16. The operation process of the input module 21 can be understood in conjunction with FIG. 16 and FIG. 17. As shown in FIG. 17, an operation of the shift register unit 20 includes a first period t1, a second period t2, a third period t3, and a fourth period t4 in chronological order.

During the first period t1, the input module 21 is turned on under the control of the high-level signal of the first clock signal CK1, to write the high level of the input signal STV to the first node Q1, write the low level of the second voltage signal VG2 to the second node Q2, and writes a low level to the ninth node Q9; meanwhile, under the control of the low level of the second clock signal CK2, the path between the tenth node Q10 and the second node Q2 is cut off. For example, the high level of the first clock signal CK1 controls the eighteenth transistor T18 in the first sub-module 211 to be turned on, so as to write the high level of the input signal STV to the fifth node Q5; and the fifth node Q5 writes the high level to the first node Q1 through the protection transistor M5. During this period, the output terminal of the first sub-module 211 is at a high level, which controls the nineteenth transistor T19 in the third sub-module 213 to be turned on, thereby writing the low level of the second voltage signal VG2 to the second node Q2. The high level of the output terminal of the first sub-module 211 also controls the thirteenth transistor T13 in the second sub-module 212 to be turned on; at the same time, the first clock signal CK1 controls the fourteenth transistor T14 to be turned on. The high level of the third voltage signal VG3 written through the fourteenth transistor T14 leaks through the thirteenth transistor T13, and the fifteenth transistor T15 is turned on under the control of the high level of the third voltage signal VG3; therefore, a low potential is written to the ninth node Q9 in this case. Since the ninth node Q9 is at a low potential and the second clock signal CK2 is at a low level, both the sixteenth transistor T16 and the seventeenth transistor T17 are turned off. During this period, the first node Q1 is at a high potential and the second node Q2 is at a low potential; and the third output transistor M3 in the output module 22 is turned on, and the output terminal OUT outputs a high-level signal.

During the second period t2, the input module 21 is turned off under the control of the low-level signal of the first clock signal CK1; the first node Q1 is maintained at a high potential, the second node Q2 and the ninth node Q9 are maintained at a low potential; and the path between the tenth node Q10 and the second node Q2 is turned on under the control of the high level of the second clock signal CK2. For example, the first clock signal CK1 is at a low level, so the eighteenth transistor T18 and the fourteenth transistor T14 are turned off. The fifth node Q5 and the first node Q1 are maintained at a high potential. During this period, the second node Q2 and the ninth node Q9 are maintained at a low potential. Moreover, the second clock signal CK2 is at a high level, which controls the seventeenth transistor T17 to be turned on, thereby enabling the path between the tenth node Q10 and the second node Q2 to be turned on. During this period, the first node Q1 is at a high potential and the second node Q2 is at a low potential; the third output transistor M3 in the output module 22 is turned on, and the output terminal OUT outputs a high-level signal.

During the third period t3, the input module 21 is turned on under the control of the high-level signal of the first clock signal CK1, so as to write the low level of the input signal STV to the first node Q1, and write the high level of the third voltage signal VG3 to the ninth node Q9; under the control of the ninth node Q9, the low level of the second clock signal CK2 is written to the tenth node Q10; meanwhile, under the control of the low level of the second clock signal CK2, the path between the tenth node Q10 and the second node Q2 is cut off, and the second node Q2 is maintained at a low potential. For example, the high-level signal of the first clock signal CK1 controls the eighteenth transistor T18 and the fourteenth transistor T14 to be turned on. The eighteenth transistor T18 is turned on to write the low level of the input signal STV to the fifth node Q5, and the fifth node Q5 writes the low level to the first node Q1 through the protection transistor M5. Meanwhile, the low level of the fifth node Q5 controls the thirteenth transistor T13 to turn off, while the fourteenth transistor T14 and the fifteenth transistor T15 are turned on to write the high level of the third voltage signal VG3 to the ninth node Q9. The high level of the ninth node Q9 controls the sixteenth transistor T16 to be turned on, so as to write the low level of the second clock signal CK2 to the tenth node Q10; the low level of the second clock signal CK2 controls the seventeenth transistor T17 to be turned off, cutting off the path between the tenth node Q10 and the second node Q2. During this period, the second node Q2 is at a low potential and the first node Q1 is at a low potential; the output terminal OUT of the output module 22 maintain the output state of the previous period and outputs a high-level signal.

During the fourth period t4, the input module 21 is turned off under the control of the low-level signal of the first clock signal CK1; the first node Q1 is maintained at a low potential, and the ninth node Q9 is maintained at a high potential; under the control of the ninth node Q9, the high level of the second clock signal CK2 is written to the tenth node Q10; due to the coupling effect of the third capacitor C3, the potential change at the tenth node Q10 pulls up the potential of the ninth node Q9 by coupling; under the control of the high level of the second clock signal CK2, the path between the tenth node Q10 and the second node Q2 is turned on, and a high potential is written to the second node Q2. During this period, the second node Q2 is at a high potential and the first node Q1 is at a low potential; the fourth output transistor M4 in the output module 22 is turned on, and the output terminal OUT outputs a low-level signal.

In some implementations, FIG. 18 is a schematic diagram of cascading of shift register units according to an embodiment of the present disclosure, as shown in FIG. 18, the shift register unit 20 includes the input module 21, the output module 22, and the voltage stabilizing module 23, an output terminal OUT of the output module 22 in an i-th stage shift register unit 20(i) is connected to an input terminal of the input module 21 in an (i+1)-th stage shift register unit 20(i+1), where i is a positive integer. That is, the signal output by the output terminal OUT of the output module 22 in the shift register unit 20 serves as the input signal STV received by the input module 21 in the next stage shift register unit 20.

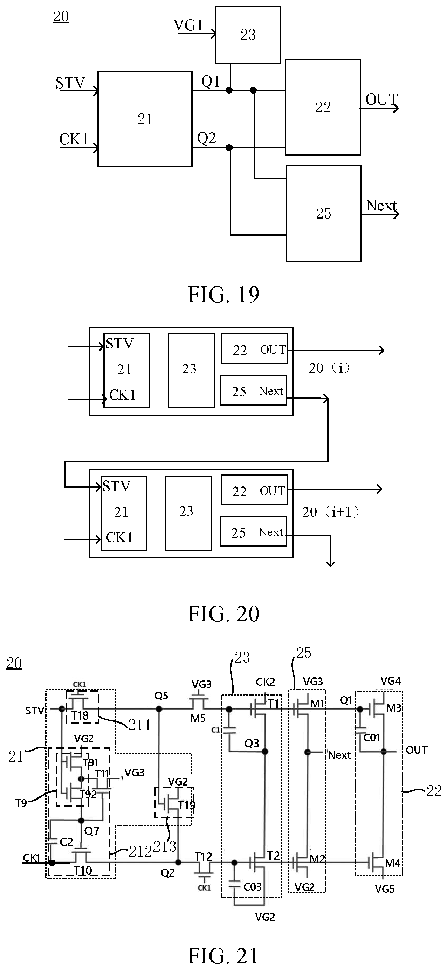

In some other implementations, FIG. 19 is a schematic diagram of another shift register unit according to an embodiment of the present disclosure, and FIG. 20 is another schematic diagram of cascading of shift register units according to an embodiment of the present disclosure. As shown in FIG. 19, the shift register unit 20 further includes a stage transfer module 25, and the stage transfer module 25 is connected to the first node Q1 and the second node Q2 respectively; and the stage transfer module 25 is configured to output a high-level signal based on the voltage of the first node Q1 and a low-level signal based on the voltage of the second node Q2. In applications, the signal output by the output terminal Next of the stage transfer module 25 is used for stage transfer to be provided to the input terminal of the next stage shift register unit, and the signal output by the output terminal OUT of the output module 22 is used to be provided to the scan line to drive the pixel circuits. This can reduce the voltage drop of the scan signal output by the shift register unit 20, which is conducive to improving display uniformity.

Referring to FIG. 20, the output terminal Next of the stage transfer module 25 in the i-th stage shift register unit 20(i) is connected to the input terminal of the input module 21 in the (i+1)-th stage shift register unit 20(i+1), where i is a positive integer. That is, the signal output by the output terminal Next of the stage transfer module 25 in the shift register unit 20 serves as the input signal STV received by the input module 21 in the next stage shift register unit 20.

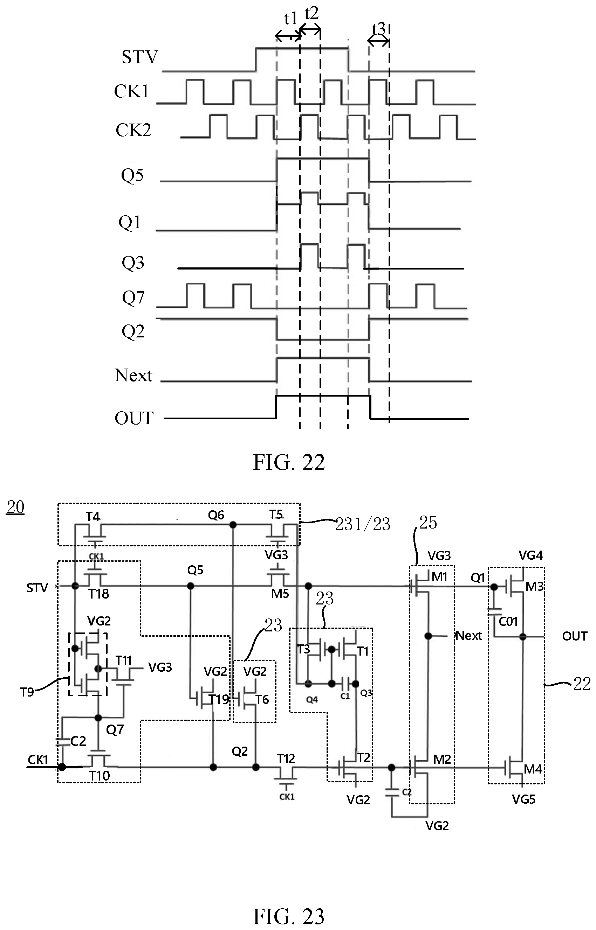

In some implementations, FIG. 21 is a schematic diagram of another shift register unit according to an embodiment of the present disclosure. FIG. 22 is another timing diagram according to an embodiment of the present disclosure, which can be used to drive the shift register unit provided by FIG. 21. As shown in FIG. 21, the shift register unit 20 includes the input module 21, the output module 22, the voltage stabilizing module 23, and the stage transfer module 25. The stage transfer module 25 includes a first output transistor M1 and a second output transistor M2. A control terminal of the first output transistor M1 is connected to the first node Q1, a first terminal of the first output transistor M1 receives a third voltage signal VG3, a second terminal of the first output transistor M1 is connected to an output terminal Next of the stage transfer module 25, a control terminal of the second output transistor M2 is connected to the second node Q2, a first terminal of the second output transistor M2 receives a second voltage signal VG2, and a second terminal of the second output transistor M2 is connected to the output terminal Next of the stage transfer module 25. For example, a protection transistor M5 is connected between the first node Q1 and the output terminal of the input module 21, and the control terminal of the second output transistor M2 is connected to the second node Q2 through the twelfth transistor T12. The third voltage signal VG3 provides a high-level signal, and the second voltage signal VG2 provides a low-level signal. FIG. 21 also shows a capacitor C03, one plate of the capacitor C03 is connected to the control terminal of the second output transistor M2, and the other plate of the capacitor C03 receives the second voltage signal VG2.

The output module 22 includes a third output transistor M3 and a fourth output transistor M4, a control terminal of the third output transistor M3 is connected to the first node Q1, a first terminal of the third output transistor M3 receives a fourth voltage signal VG4, a second terminal of the third output transistor M3 is connected to an output terminal OUT of the output module 22, a control terminal of the fourth output transistor M4 is connected to the second node Q2, a first terminal of the fourth output transistor M4 receives a fifth voltage signal VG5, and a second terminal of the fourth output transistor M4 is connected to the output terminal OUT of the output module 22. For example, the control terminal of the fourth output transistor M4 is connected to the second node Q2 through the twelfth transistor T12. The fourth voltage signal VG4 provides a high-level signal, and the fifth voltage signal VG5 provides a low-level signal.

In addition, in the embodiment of FIG. 21, the input module 21 has the same structure as the input module 21 in the embodiment of FIG. 10, and the voltage stabilizing module 22 has the same structure as the voltage stabilizing module 22 in the embodiment of FIG. 1; and details thereof will not be repeated here.

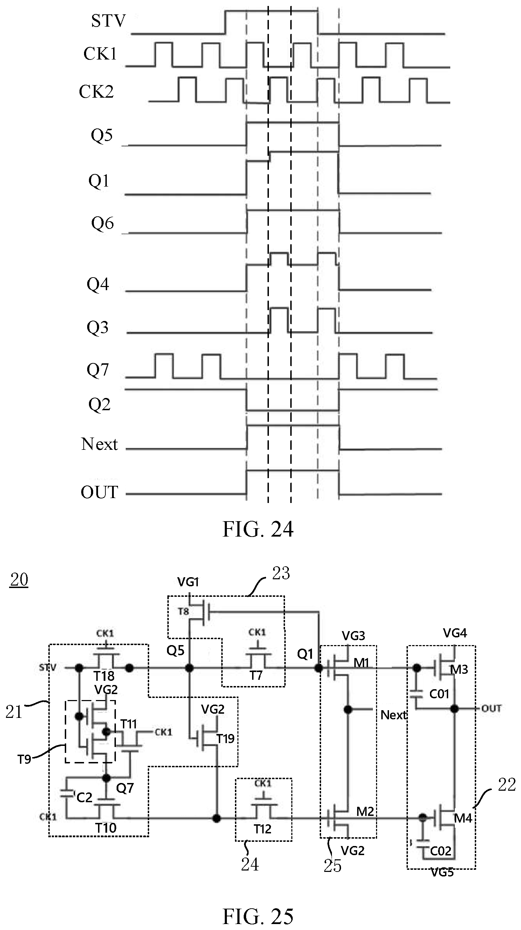

In some other implementations, FIG. 23 is a schematic diagram of another shift register unit according to an embodiment of the present disclosure. FIG. 24 is another timing diagram according to an embodiment of the present disclosure, which can be used to drive the shift register unit provided in FIG. 23. As shown in FIG. 23, the shift register unit 20 includes an input module 21, an output module 22, a voltage stabilizing module 23, and a stage transfer module 25. In the embodiment of FIG. 23, the input module 21 has the same structure as the input module 21 in the embodiment of FIG. 10, and the voltage stabilizing module 22 has the same structure as the voltage stabilizing module 22 in the embodiment of FIG. 10.

In some other implementations, FIG. 25 is a schematic diagram of another shift register unit according to an embodiment of the present disclosure. As shown in FIG. 25, the shift register unit 20 includes an input module 21, an output module 22, a voltage stabilizing module 23, a leakage prevention module 24, and a stage transfer module 25. In the embodiment of FIG. 23, the input module 21 has the same structure as the input module 21 in the embodiment of FIG. 10, and the voltage stabilizing module 22 has the same structure as the voltage stabilizing module 22 in the embodiment of FIG. 11.

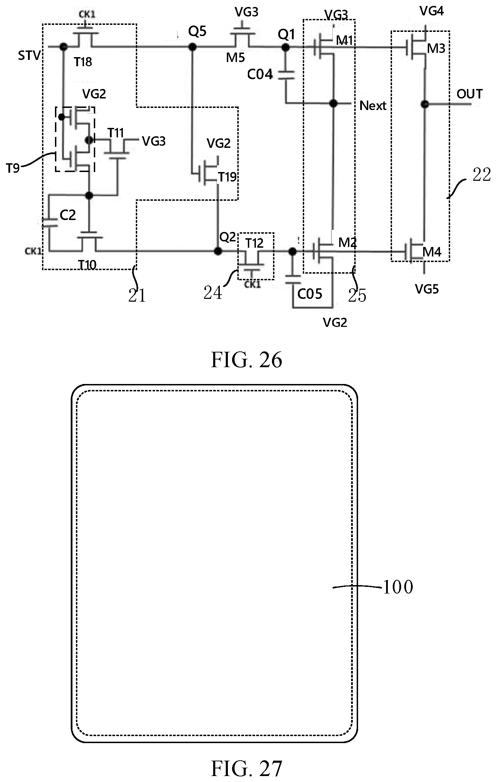

In other implementations, FIG. 26 is a schematic diagram of another shift register unit according to an embodiment of the present disclosure. As shown in FIG. 26, the shift register unit 20 includes an input module 21, an output module 22, a leakage prevention module 24, and a stage transfer module 25. FIG. 26 also shows a capacitor C04 and a capacitor C05.

In some implementations, the third voltage signal VG3 and the fourth voltage signal VG5 each provide a high-level signal, a voltage value of the third voltage signal VG3 is VGH1, a voltage value of the fourth voltage signal VG4 is VGH2, where VGH2≤VGH1. Such a setting enables the potential of the first node Q1 to control the third output transistor M3 to be more fully turned on, so that the output terminal OUT of the output module 22 outputs a high-level enable level more stably.

In some implementations, the second voltage signal VG2 and the fifth voltage signal VG5 each provide a low-level signal, a voltage value of the second voltage signal VG2 is VGL1, and a voltage value of the fifth voltage signal VG5 is VGL2, where VGL2≥VGL1. Such a setting enables the fourth output transistor M4 to be in a negatively biased state; and when the output terminal OUT of the output module 22 outputs a high level, the fourth output transistor M4 can be completely turned off, thereby ensuring the stability of the high level output by the output terminal OUT of the output module 22.

Based on the same inventive concept, an embodiment of the present disclosure further provides a display apparatus. FIG. 27 is a schematic diagram of a display apparatus according to an embodiment of the present disclosure. As shown in FIG. 27, the display apparatus includes the display panel 100 provided by any one of the embodiments of the present disclosure. The structure of the display panel has been described in the foregoing embodiments, and details thereof will not be repeated herein. The display apparatus according to the embodiment of the present disclosure may be, for example, a mobile phone, a tablet, a television, a smart wearable product, or other electronic devices.

The above are merely preferred embodiments of the present disclosure and are not intended to limit the present disclosure. Any modification, equivalent replacement, improvement, etc., made within the spirit and principle of the present disclosure shall be included within the protection scope of the present disclosure.

Finally, it should be noted that the foregoing embodiments are only used to describe the technical solutions of the present disclosure, and are not intended to limit the same; although the present disclosure has been described in detail with reference to the foregoing embodiments, those of skill in the art should understand that they can still modify the technical solutions recited in the foregoing embodiments, or make equivalent replacements to some or all of the technical features therein; and such modifications or replacements do not cause the essence of the corresponding technical solutions to deviate from the scope of the technical solutions of the embodiments of the present disclosure.

## Claims

1. A display panel, comprising a shift register, wherein the shift register comprises a plurality of shift register units each comprising an input module, an output module, and a voltage stabilizing module;
the input module is configured to write a voltage to a first node and a second node respectively at least based on an input signal and a first clock signal;
the output module is connected to the first node and the second node respectively, and the output module is configured to output a high-level signal based on the voltage of the first node and further configured to output a low-level signal based on the voltage of the second node; and
the voltage stabilizing module is at least connected to the first node, and the voltage stabilizing module is configured to pull up a potential of the first node based on the voltage of the first node and a first voltage signal during at least part of periods when the first node is at a high potential.

2. The display panel according to claim 1, wherein
an operation of the shift register unit comprises a first period and a second period, and the first node is at the high potential during the first period and the second period; and
during the first period, the voltage of the first node is V1; and during the second period, the voltage of the first node is V2, where V2>V1.

3. The display panel according to claim 2, wherein
the operation of the shift register unit comprises m first periods and m second periods, where m is an integer and m≥1; and
in chronological order, the first periods and the second periods are arranged alternately, and a first one of the first periods is earlier than a first one of the second periods.

4. The display panel according to claim 3, wherein
during the first periods, the input module writes the high potential to the first node based on a high-level of the first clock signal, and the voltage stabilizing module writes, under the control of the first node, a low-level of the first voltage signal to a third node in the voltage stabilizing module; and
during the second periods, the voltage stabilizing module writes a high-level of the first voltage signal to the third node under the control of the first node, and pulls up the potential of the first node based on a potential change at the third node.

5. The display panel according to claim 2, wherein
in chronological order, the first period is earlier than the second period; and
a length of the first period is t01, and a length of the second period is t02, where t02>t01.

6. The display panel according to claim 5, wherein
during the first period, the input module writes a high potential to the first node based on a high-level of the first clock signal, and the voltage stabilizing module writes, under the control of the high-level of the first clock signal, a high level of the input signal to a fourth node in the voltage stabilizing module, and writes a low-level of the first voltage signal to a third node under the control of a high potential of the fourth node;
the second period comprises a first sub-period and a second sub-period;
during the first sub-period, the voltage stabilizing module writes a high-level of the first voltage signal to the third node under the control of the fourth node, and pulls up the potential of the fourth node based on a potential change at the third node, wherein a voltage of the fourth node is V3, the voltage of the fourth node is written to the first node via a unidirectional conduction between the fourth node and the first node; and
during the second sub-period, the voltage stabilizing module writes the low-level of the first voltage signal to the third node under the control of the high potential of the fourth node, and the voltage stabilizing module writes a voltage of the input signal to the fourth node under the control of the high-level of the first clock signal, wherein the voltage of the fourth node Q4 is V4 and V4<V3.

7. The display panel according to claim 1, wherein
an operation of a shift register unit comprises a first period and a second period, and the first node is at the high potential during the first period and the second period;
during the first period, the first clock signal is at high-level, the first voltage signal is at high-level, the voltage stabilizing module writes the high-level of the first voltage signal to a fifth node under the control of the first node, and writes a high potential of the fifth node to the first node under the control of the first clock signal; and
during the second period, the first clock signal is at low-level, the first voltage signal is the high-level signal, the voltage stabilizing module writes the high-level of the first voltage signal to the fifth node under the control of the first node, and cuts off a path between the fifth node and the first node under the control of the first clock signal.

8. The display panel according to claim 1, wherein
the voltage stabilizing module comprises a first transistor, a second transistor, and a first capacitor;
a control terminal of the first transistor is connected to the first node, a control terminal of the second transistor is connected to the second node, a first terminal of the first transistor receives the first voltage signal, a second terminal of the first transistor and a second terminal of the second transistor are connected to a third node, and a first terminal of the second transistor receives a second voltage signal; and
one plate of the first capacitor is connected to the first node, and the other plate of the first capacitor is connected to the third node.

9. The display panel according to claim 8, wherein
the first voltage signal is a second clock signal.

10. The display panel according to claim 8, wherein
the voltage stabilizing module further comprises a third transistor and an input sub-module;
the control terminal of the first transistor, one plate of the first capacitor, a control terminal of the third transistor are connected to a fourth node, a first terminal of the third transistor is connected to the fourth node, and a second terminal of the third transistor is connected to the first node; and
an output terminal of the input sub-module is connected to the fourth node, and the input sub-module is configured to write a voltage to the fourth node based on the input signal and the first clock signal.

11. The display panel according to claim 10, wherein
the input sub-module comprises a fourth transistor and a fifth transistor; and
a control terminal of the fourth transistor receives the first clock signal, a first terminal of the fourth transistor receives the input signal, and a second terminal of the fourth transistor is connected to a sixth node; and a control terminal of the fifth transistor receives a third voltage signal, a first terminal of the fifth transistor is connected to the sixth node, and a second terminal of the fifth transistor is connected to the fourth node.

12. The display panel according to claim 11, wherein
the voltage stabilizing module further comprises a sixth transistor, a control terminal of the sixth transistor is connected to the sixth node, a first terminal of the sixth transistor receives the second voltage signal, and a second terminal of the sixth transistor is connected to the second node.

13. The display panel according to claim 1, wherein
the voltage stabilizing module comprises a seventh transistor and an eighth transistor;
a control terminal of the seventh transistor receives the first clock signal, a first terminal of the seventh transistor and one output terminal of the input module are connected to a fifth node, and a second terminal of the seventh transistor is connected to the first node; and
a control terminal of the eighth transistor is connected to the first node; a first terminal of the eighth transistor receives the first voltage signal, wherein the first voltage signal is the input signal or the high-level signal; and a second terminal of the eighth transistor is connected to the fifth node.

14. The display panel according to claim 1, wherein
the input module comprises a first sub-module, a second sub-module, and a third sub-module;
the first sub-module is configured to write a voltage to the first node based on the input signal and the first clock signal;
the second sub-module is configured to write a high level to the second node at least based on the input signal and the first clock signal; and
the third sub-module is configured to write a low level to the second node under the control of an output signal of the first sub-module.

15. The display panel according to claim 14, wherein
the second sub-module comprises a ninth transistor, a tenth transistor, and a second capacitor;
a control terminal of the ninth transistor receives the input signal, a first terminal of the ninth transistor receives a second voltage signal, and a second terminal of the ninth transistor is connected to a control terminal of the tenth transistor at a seventh node; a first terminal of the tenth transistor receives the first clock signal, a second terminal of the tenth transistor is connected to the second node Q2; and one plate of the second capacitor receives the first clock signal, and the other plate of the second capacitor is connected to the seventh node.

16. The display panel according to claim 15, wherein
the ninth transistor comprises a first sub-transistor and a second sub-transistor, a control terminal of the first sub-transistor and a control terminal of the second sub-transistor each receive the input signal, a first terminal of the first sub-transistor receives the second voltage signal, a second terminal of the first sub-transistor and a first terminal of the second sub-transistor are connected to an eighth node, and a second terminal of the second sub-transistor is connected to the seventh node; and
the second sub-module further comprises an eleventh transistor, a control terminal of the eleventh transistor is connected to the seventh node or the second terminal of the tenth transistor, a first terminal of the eleventh transistor receives a third voltage signal or the first clock signal, and a second terminal of the eleventh transistor is connected to the eighth node.

17. The display panel according to claim 1, wherein
the shift register unit further comprises a leakage prevention module, the leakage prevention module is connected between the second node and the output module, and the leakage prevention module is configured to be turned off under the control of the first clock signal.

18. The display panel according to claim 17, wherein
the leakage prevention module comprises a twelfth transistor, a control terminal of the twelfth transistor receives the first clock signal, a first terminal of the twelfth transistor is connected to the second node, and a second terminal of the twelfth transistor is connected to one control terminal of the output module.

19. The display panel according to claim 1, wherein
the input module comprises a first sub-module, a second sub-module, and a third sub-module;
the first sub-module is configured to write a voltage to the first node based on the input signal and the first clock signal;
the second sub-module is configured to write a voltage to the second node at least based on an output signal of the first sub-module, the first clock signal, and a second clock signal; and
the third sub-module is configured to write a low level to the second node under the control of the output signal of the first sub-module.

20. The display panel according to claim 19, wherein
the second sub-module comprises a thirteenth transistor, a fourteenth transistor, a fifteenth transistor, a sixteenth transistor, and a seventeenth transistor;
a control terminal of the thirteenth transistor is connected to an output terminal of the first sub-module, a first terminal of the thirteenth transistor receives a second voltage signal, and a second terminal of the thirteenth transistor is connected to a second terminal of the fourteenth transistor; a control terminal of the fourteenth transistor receives the first clock signal; a control terminal of the fifteenth transistor receives a third voltage signal; a first terminal of the fourteenth transistor receives the third voltage signal, and the second terminal of the fourteenth transistor is connected to a first terminal of the fifteenth transistor; a second terminal of the fifteenth transistor and a control terminal of the sixteenth transistor are connected to a ninth node;
a first terminal of the sixteenth transistor receives the second clock signal, and a second terminal of the sixteenth transistor is connected to a tenth node; and
a control terminal of the seventeenth transistor receives the second clock signal, a first terminal of the seventeenth transistor is connected to the tenth node, and a second terminal of the seventeenth transistor is connected to the second node.

21. The display panel according to claim 14 or 19, wherein
the first sub-module comprises an eighteenth transistor, a control terminal of the eighteenth transistor receives the first clock signal, a first terminal of the eighteenth transistor receives the input signal, and a second terminal of the eighteenth transistor is connected to the first node; and/or
the third sub-module comprises a nineteenth transistor, a control terminal of the nineteenth transistor is connected to an output terminal of the first sub-module, a first terminal of the nineteenth transistor receives a second voltage signal, and a second terminal of the nineteenth transistor is connected to the second node.

22. The display panel according to claim 1, wherein
an output terminal of the output module in an i-th stage shift register unit is connected to an input terminal of the input module in an (i+1)-th stage shift register unit, where i is a positive integer.

23. The display panel according to claim 1, wherein
the shift register unit further comprises a stage transfer module, the stage transfer module is connected to the first node and the second node respectively, and the stage transfer module is configured to output a high-level signal based on the voltage of the first node and a low-level signal based on the voltage of the second node; and
an output terminal of the stage transfer module in an i-th stage shift register unit is connected to an input terminal of the input module in an (i+1)-th stage shift register unit, where i is a positive integer.

24. The display panel according to claim 23, wherein
the stage transfer module comprises a first output transistor and a second output transistor; a control terminal of the first output transistor is connected to the first node, a first terminal of the first output transistor receives a third voltage signal, and a second terminal of the first output transistor is connected to an output terminal of the stage transfer module; and a control terminal of the second output transistor is connected to the second node, a first terminal of the second output transistor receives a second voltage signal, and a second terminal of the second output transistor is connected to the output terminal of the stage transfer module; and
the output module comprises a third output transistor and a fourth output transistor; a control terminal of the third output transistor is connected to the first node, a first terminal of the third output transistor receives a fourth voltage signal, and a second terminal of the third output transistor is connected to an output terminal of the output module; and a control terminal of the fourth output transistor is connected to the second node, a first terminal of the fourth output transistor receives a fifth voltage signal, and a second terminal of the fourth output transistor is connected to the output terminal of the output module; and wherein
a voltage value of the third voltage signal is VGH1, a voltage value of the fourth voltage signal is VGH2, where VGH2≤VGH1; and/or
a voltage value of the second voltage signal is VGL1, a voltage value of the fifth voltage signal is VGL2, where VGL2≥VGL1.

25. The display panel according to claim 1, wherein
at least a transistor in the output module that is connected to the first node is an n-type transistor.

26. The display panel according to claim 25, wherein
all transistors in the shift register unit are n-type transistors.

27. The display panel according to claim 25, wherein
an active layer of the n-type transistor comprises indium gallium zinc oxide.

28. A display apparatus, comprising the display panel according to any one of claims 1 to 27.
